# NEW EUROPEAN PATENT SPECIFICATION

(11) **EP 0 426 406 B2**
(45) Date of publication and mention of the opposition decision: **19.08.1998**
(45) Mention of the grant of the patent: 10.05.1995
(21) Application number: 90311820.6
(22) Date of filing: 29.10.1990
(51) Int. Cl.: G06K 19/06, G06K 19/077

(54) **IC card having an integrated circuit module**
IC-Karte mit integriertem Schaltkreismodul
Carte pourvue d'un module à circuit intégré

(30) Priority: 31.10.1989 JP 281907/89
(43) Date of publication of application: 08.05.1991
(73) Proprietor: Citizen Watch Co., Ltd., Shinjuku-ku Tokyo (JP)
(72) Inventor: Oka, Tomoshige, Tokorozawa-shi, Saitama (JP); Hiraishi, Shigeo, Tokorozawa-shi, Saitama (JP); Ibuki, Yoshiteru, Sayama-shi, Saitama (JP); Kaneko, Hiroyuki, Kunitachi-shi, Tokyo (JP)
(74) Representative: Molyneaux, Martyn William

(56) References cited:
- US-A- 4 552 383
- US-A- 4 737 620
- US-A- 4 792 843
- PATENT ABSTRACTS OF JAPAN vol. 12, no. 330 (E-655)7 September 1988 & JP-A-63 094 646

## Description

### BACKGROUND OF THE INVENTION

### Field of the Invention

The present invention relates to an IC (integrated circuit) card, and more particularly to structure for securing an IC module to a card base.

### Description of the Prior Arts

The IC card has an IC chip having a CPU and memories. Since the recent IC card has a larger storage capacity than a conventional IC card, its use in place of a bankbook or a credit card is into consideration.

The IC module including the IC chip is mounted in the IC card. However, there are various problems in the mounting of the IC module.

Japanese Patent Application Laid-open 63-94646 and Japanese Utility Model Application Laid-open 61-46655 disclose IC module mounting structure.

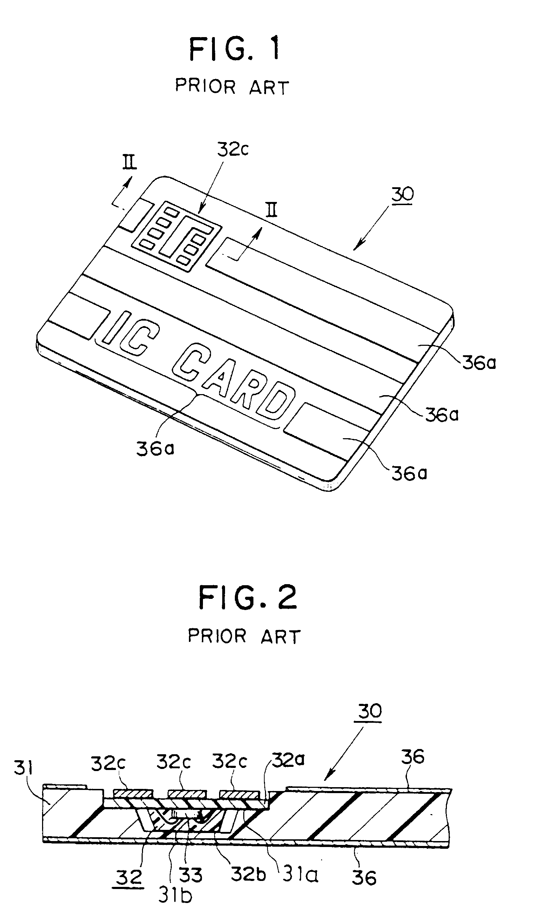

Fig. 1 shows an external appearance of conventional IC card and Fig. 2 is a sectional view taken on a line II-II of Fig. 1 and shows the IC module mounting structure.

The IC card 30 comprises a plastic card base 31, an IC module 32 embedded in the card base 31, and an overlay 36 on which various ornament patterns and characters 36a are printed. The IC module 32 has a plurality of contact patterns 32c which are exposed to the outside.

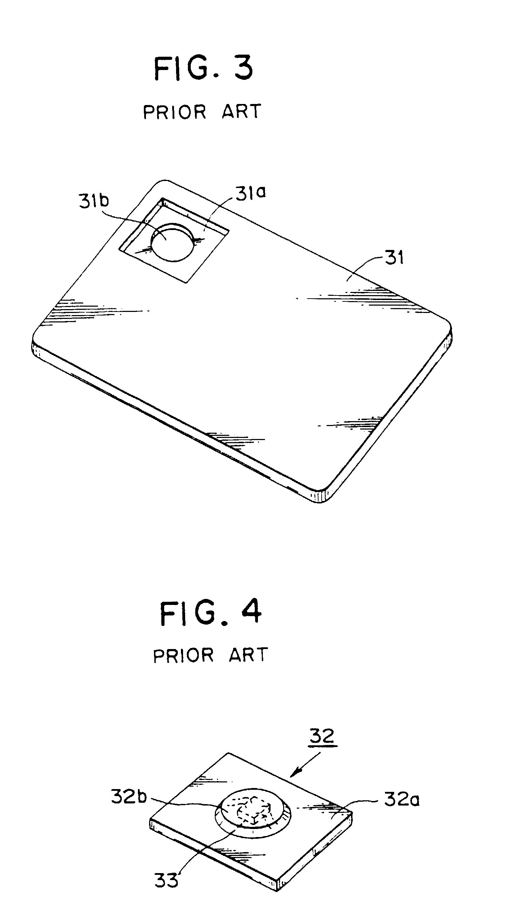

Describing the mounting of the IC module, a first recess 31a and a second recess 31b for housing the IC module 32 are formed in the card base 31 as shown in Fig. 3. The card base 31 is made by injection molding of ABS resin or by multi-layer laminating PVC (polyvinyl chloride) sheets. As shown in Fig. 4, the IC module 32 is designed in such a way that an IC chip 33 is bonded to a circuit board 32a made of glass epoxy resin, and a seal portion 32b of sealing resin is formed on the circuit board 32a to seal the IC chip 33. On the other hand, the contact patterns 32c shown in Fig. 1 are formed on the back side of the circuit board 32a.

As shown in Fig. 2, the seal portion 32b of the IC module 32 is housed in the second recess 31b of the card base 31, and the circuit board 32a is housed in the first recess 31a, while the outer periphery of the circuit board 32a is restricted by the peripheral wall of the first recess 31a, and the surfaces of the contact patterns are coplanar as the card base 31. A liquid adhesive (not shown) is supplied into spaces among the circuit board 32a, the sealing portion 32b, the first recess 31a, and the second recess 31b, and heated to be solidified. Thus, the IC module 32 is securely mounted on the card base 31.

Generally, the IC card 30 has a small thickness as about 0.8 mm, and hence it must have an elasticity enough to allow to be bent to a certain extent so as not to be broken by an external force exerted thereon in use. Therefore, it is required that the card base 31 has an elasticity, while the seal portion 32b of the IC module 32 has a rigidity sufficient for protecting the IC module, and that the IC module 32 is firmly fixed to the card base 31.

Since the material of the circuit board 32a and the seal portion 32b constituting the IC module 32 is different from that of the card base 31, it is difficult to obtain a liquid adhesive capable of reliably bonding them to each other. In addition, the adhesive strength in an adhesion state of the IC module changes with the adhered position thereof. Consequently, when the card base 31 is fixed, separation of an adhered portion between the card base 31 and the IC module 32 may occur. As a result, the IC module 32 may separate from the card base 31.

When the liquid adhesive is heated, it can leak from a portion of the gap between the circuit board 32a and the first recess 31a depending on the amount of the liquid adhesive and the bonding position. As a result, the surface of the overlay 36 on which pattern and characters 36a are printed may be contaminated. In addition, the card base 31 tends to deform because of the heat at the time when the liquid adhesive is heated.

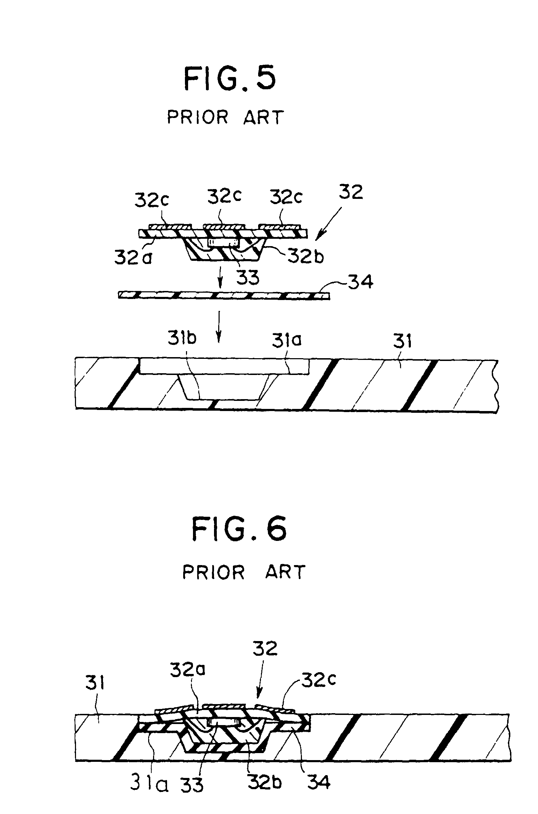

Moreover, the liquid adhesive inherently has poor handling properties and workability. Therefore, there has been a demand for IC card structure in which the IC module can be secured to the card base without using the liquid adhesive. Such IC card structures are shown in Fig. 5 to Fig. 8. In Fig. 5 to Fig. 8, the same reference numerals as those of Fig. 1 to Fig. 4 designate same parts as Figs. 1 to 4, and hence explanation thereof is omitted hereinafter.

The IC card structure shown in Fig. 5 is disclosed in U.S. Patent 4,792,843. In assembling the IC module 32, an adhesive sheet 34 (called hot melting sheet) is fitted in the first recess 31a and the second recess 31b. The IC module 32 is put in the card base 31 so that the seal portion 32b of the IC module 32 and the circuit board 32a are located in the second recess 31b and the first recess 31a of the card base 31. The upper side of the IC module 32 is heated and downwardly pressed by a heat and pressure applying apparatus (not shown), so that the adhesive sheet 34 laid between the IC module 32 and the first and second recesses 31a and 31b melts, and solidifies when it cools, thereby fixing the IC module 32 to the card base 31.

Recently, the adhesive sheet is greatly improved in adhesive strength, and hence it is available for assembling IC module. In particular, the adhesive sheet 34 does not leak from the gap between the IC module 32 and the first and second recesses 31a and 31b when heat and pressure are applied thereto.

However, there is a problem that the upper surface of the circuit board 32a swells as shown in Fig. 6. It is thought that the swelling occurs from the following reason.

Since the seal portion 32b sealing the IC chip 33 is required to be formed as thin as possible, a transfer molding method using a thermosetting resin is used for forming the seal portion. However, there are considerable variations in dimension of the solidified seal portions formed by the transfer molding method.

On the other hand, the recesses 31a and 31b of the card base 31 are formed when the card base 31 is formed by the injection molding process of ABS resin, or the recesses are formed by cutting the card base after the multi-layer laminating of PVC sheets.

In the injection molding process, the ABS resin shrinks when it cools and solidifies. and thus the thickness of the bottom of the second recess 31 decreases and variations have been easily produced in the depth of the second recess 31b. In the cutting process, the recess can not be formed with accuracy, causing thickness variance of the bottom of the recess.

If the IC module is formed thick and the card base 31 is formed into a shallow second recess, the seal portion 32b of the IC module 32 may project from the second recess 31 b. If the swelled IC module is forcibly packed in the second recess 31b, the underside of the card base 31 (the opposite surface to the second surface 31b) swells, thus, deteriorating the external appearance of the IC card.

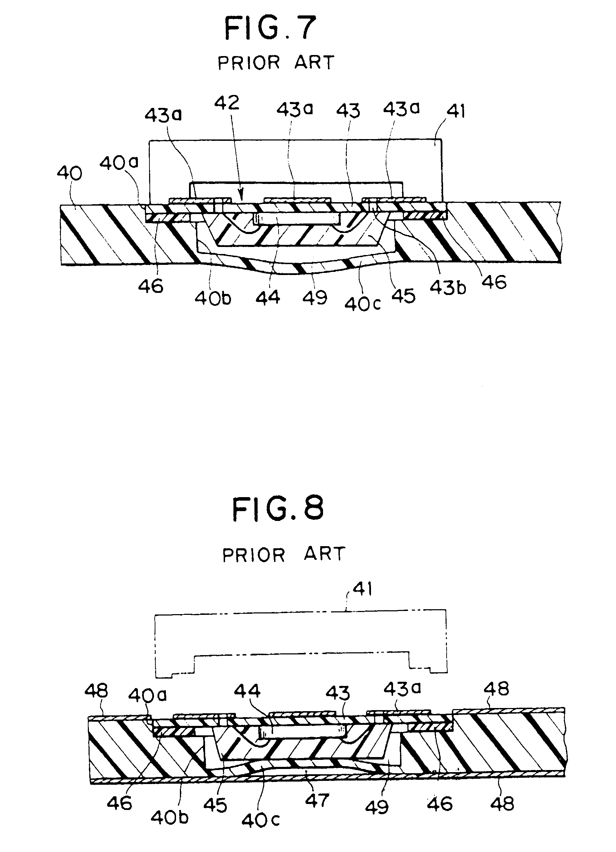

U.S. Patent 4,552,383 discloses an IC card which may solve the above described problems. Fig. 7 and Fig. 8 show the IC card. In Fig. 7, a reference numeral 40 designates a card base which is provided with a first recess 40a and a second recess 40b. An IC module 42 comprises a circuit board 43 having contact patterns 43a on the upper surface thereof, an IC chip 44 mounted on the circuit board 43, and a sealing portion 45 for sealing the IC chip. The IC chip 44 and contact patterns 43a are connected to each other by bonding wires and through hole patterns 43b. An adhesive sheet 46 is provided only between a peripheral portion of the circuit board 43 and a bottom of the first recess 40a. A heat and pressure applying apparatus 41 is set on the upper surface of the circuit board 43 of the IC module 42 to heat and press the IC module. Thus, the adhesive sheet 46 is melted so that only the peripheral portion of the circuit board 43 is fixed to the bottom of the first recess 40a.

The peripheral sides of the circuit board 43 engage with the inner wall of the first recess 40a, thereby positioning the IC module 42. The second recess 40b has sufficient depth and a capacity to allow shape variation of the seal portion 45 of the IC module 42. The IC module 42 is mounted in the first and second recesses 40a and 40b with a space 49 between the seal portion 45 and the bottom of the second recess 40b. However, according to circumstances, the underside of the seal portion 45 may contact with the bottom of the second recess 40b.

Although the seal portion 45 has not high accuracy in dimension, it is kept free from the second recess 40b by providing the gap therebetween. Furthermore, only the periphery portion of the circuit board 43 which has high accuracy is fixed to the first recess 40a through the adhesive sheet 46. Consequently, the swelling of the IC module is prevented.

As mentioned above, it is most important in the IC card that the IC module is firmly fixed to the card base, but it is also important that the surface of the card base 31 is kept smooth and flat until the overlay or the printing and a hard coat are performed thereon.

However, the IC card structure has a defect that a depression is formed in the thin portion 40c of the card base 40 as shown in Fig. 8. This is caused for the following reason. As shown in Fig. 7, the IC module 42 is mounted on the card base 40 with only the periphery portion of the circuit board 43, fixed on the first recess 40a through the adhesive sheet 46. When the heat and pressure applying apparatus 41 set on the circuit board 43 heats the adhesive sheet 46, the heat is transmitted not only to the adhesive sheet 46 but also to the card base 40, thereby heating the air in the space 49 between the seal portion 45 and the second recess 40b. While being heated, the air in the space 49 is expanded. Therefore, the thin portion 40c projects outwardly and a apart of the air discharges from the space 49. When the card base is cooled, the temperature of the air in the space 49 falls to a normal temperature, so that the volume of the air decreases and the pressure in the space is decompressed. Thus, the pressure of the air in the space becomes lower than the atmospheric pressure, so that the thin portion 40c is pushed into the space to produce a depression 47 as shown in Figure 8. The depression 47 causes incomplete adhesion between the hard coat and the card base, and hence the printing on the hard coat may be bad at the depression.

### SUMMARY OF THE INVENTION

The object of the present invention is to provide an IC card in which the IC module is fixed to the card base by a thermo reactive adhesive without forming a depression on the card base.

According to this invention there is provided an IC card as claimed in claim 1 herein.

In a preferred embodiment of the invention, the opening is formed in the card base.

In a further preferred embodiment, the opening is a through hole formed in the circuit board for connecting the contact pattern with the IC chip.

The objects and features of the present invention will become more apparent from the following detailed description with reference to the accompanying drawings.

### BRIEF DESCRIPTION OF THE DRAWINGS

Figure 1 is a perspective view showing a conventional IC card;
Figure 2 is a sectional view taken along a line II-II of Figure 1;
Figure 3 is a perspective view showing a card base of the conventional IC card;
Figure 4 is a perspective view showing an IC module to be mounted in the IC card;
Figure 5 is an exploded sectional view showing a main part of another conventional IC card;
Fig. 6 is a sectional view showing the internal structure of the conventional IC card of Fig. 5;
Fig. 7 is a sectional view of a main part of still another conventional IC card, which shows a step during a manufacturing process;
Fig. 8 is a sectional view showing the finished IC card after the step of Fig. 7;
Fig. 9 is a plan view showing a main part of an IC card according to a first embodiment of the present invention;
Fig. 10 is a sectional view taken along a line X-X of Fig. 9;
Fig. 11 is a perspective view showing an adhesive sheet used in the present invention;
Fig. 12 is a sectional view showing a main part of IC card according to an improvement of the first embodiment of the present invention;
Fig. 13 is a plan view showing a main part of an IC card according to a second embodiment of the present invention;
Fig. 14 is a sectional view taken along a line XIV-XIV of Fig. 13;
Fig. 15 is a plan view showing a main part of an IC card which is not an embodiment of the present invention;
Fig. 16 is a sectional view taken along a line XVI-XVI of Fig. 15;
Fig. 17 is a plan view showing a main part of an IC card according to a third embodiment of the present invention;
Fig. 18 is a sectional view taken along a line XVIII-XVIII of Fig. 17;
Fig. 19 is a plan view showing a main part of an IC card which is not an embodiment of the present invention;
Fig. 20 is a sectional view taken along a line XX-XX of Fig. 19;
Fig. 21 is a perspective view showing another adhesive sheet; and
Fig. 22 is a perspective view showing still another adhesive sheet which is used in Figs 15 and 16.

### DETAILED DESCRIPTION OF THE PREFERRED EMBODIMENTS

The present invention will now be described in detail with reference to the drawings.

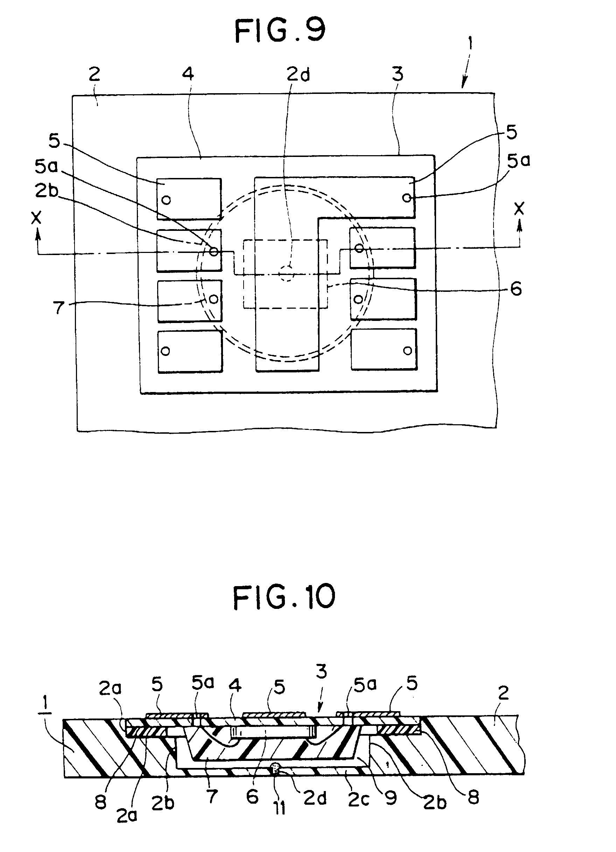

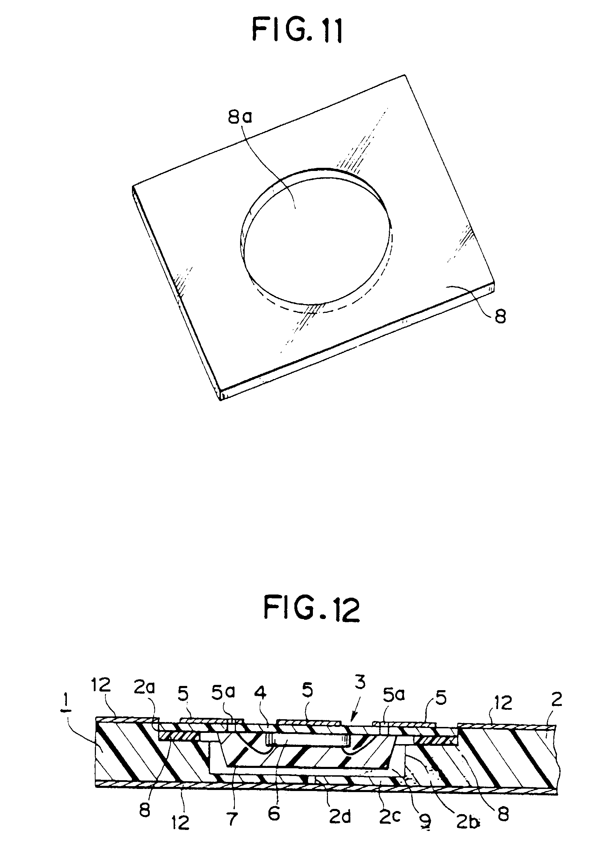

Referring to Figs. 9 and 10, an IC card 1 comprises a card base 2 having a first recess 2a, a second recess 2b, an IC module 3, and an adhesive sheet 8. The second recess 2b has a circular shape in plan view and is positioned at a central portion of the first recess 2a as shown in Fig. 9. Athin portion 2c defining the bottom of the second recess 2b has an opening 2d. As shown in Fig. 11, the adhesive sheet 8 has an opening 8a for receiving the IC module 3.

The IC module 3 comprises a circuit board 4 having a contact patterns 5 formed on the upper surface thereof, an IC chip 6 mounted on the underside of the circuit board 4, and a seal portion 7 which seals the IC chip 6 by the transfer molding method using a thermosetting resin. The IC chip 6 and contact patterns 5 are connected by bonding wires and through hole electrodes 5a. The adhesive sheet 8 is put in the first recess 2a and the circuit board 4 of the IC module is put on the adhesive sheet. The outer peripheral sides of the circuit board 4 are restricted by inner walls of the first recess 2a, and only the underside of the peripheral portion of the circuit board 2a is fixed to the first recess 2a through the adhesive sheet 8. The seal portion 7 of the IC module 3 is housed in the second recess 2b.

When the air in the space 9 expands with the heating of the IC module 3, a part of the air discharges from the space 9 passing through the opening 2d, and hence the pressure difference between the space 9 and the atmosphere does not occur. On the other hand, after applying heat and pressure, the thin portion 2c is not depressed when cooled, because the space 9 is not decompressed through the opening 2d. The opening 2d is filled with a seal member 11 such as an adhesive as shown in Fig. 10. Moreover, an overlay or a hard coat is adhered on the card base 2 to cover the seal member 11.

However, the seal member 11 may be omitted as shown in Fig. 12, because the opening 2d of the card base 2 is perfectly closed by an overlay 12.

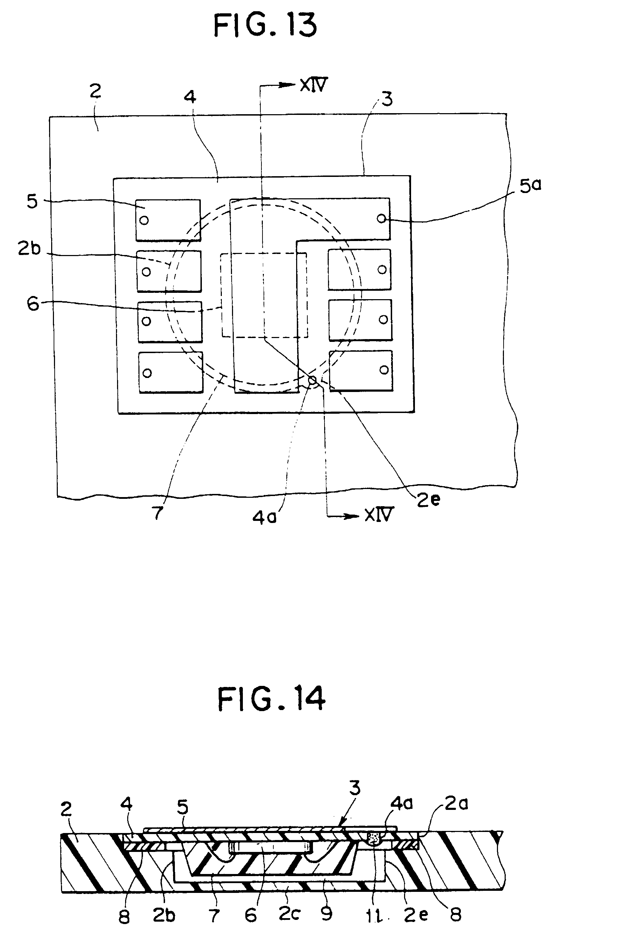

Referring to Figs. 13 and 14 showing the second embodiment of the present invention, the circuit board 4 has an opening 4a at such a position that the space 9 and the atmosphere are communicated with each other through the opening 4a. The opening is formed at the time when through hole electrodes 5a are formed in the contact patterns 5.

However, it may be difficult to form the opening 4a at a desired position so as to communicate with the space between the peripheral side wall and the inner wall of the second recess 2b, because the width of the space is small. In order to solve such a problem, an indentation 2e is formed in the inner wall of the second recess 2b to widen the space, and the opening 4a is formed to communicate with the widened space as shown in Fig. 14.

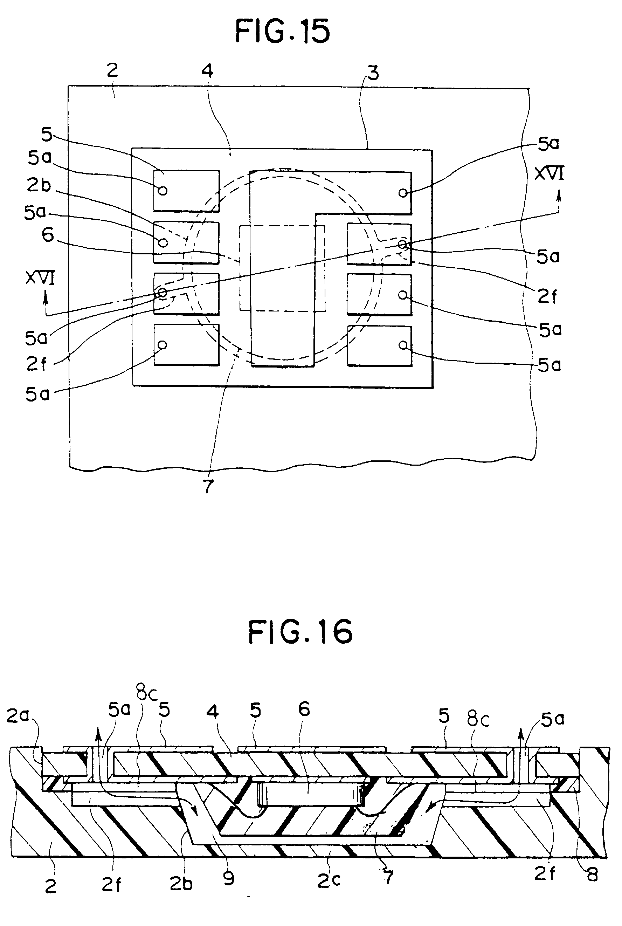

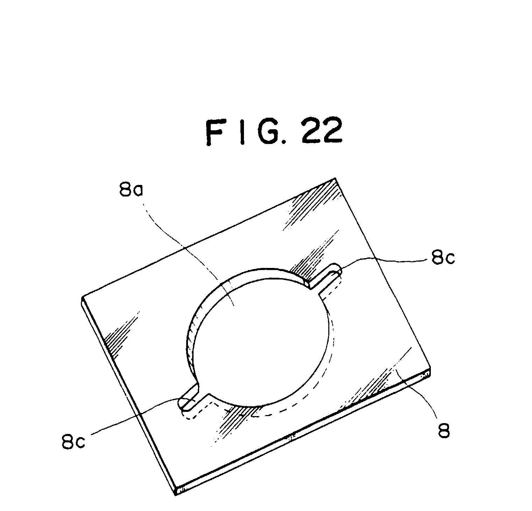

Referring to Figs. 15, 16 and 22, the IC card is characterized in that the space 9 in the second recess 2b communicates with the atmosphere through the through hole electrodes 5a. More particularly, a pair of through hole electrodes 5a which are positioned symmetrically about the center of the second recess 2b are selected, each of which communicates with the space 9 through a groove 2f formed in the bottom of the first recess 2a. A pair of slits 8c are further provided in the adhesive sheet 8 so as to communicate the groove 2f with the through hole electrode 5a.

Since the through hole electrodes 5a are used for the opening for the space 9, additional openings are not provided in the surface of the IC card. Thus, an IC card without defects can be produced.

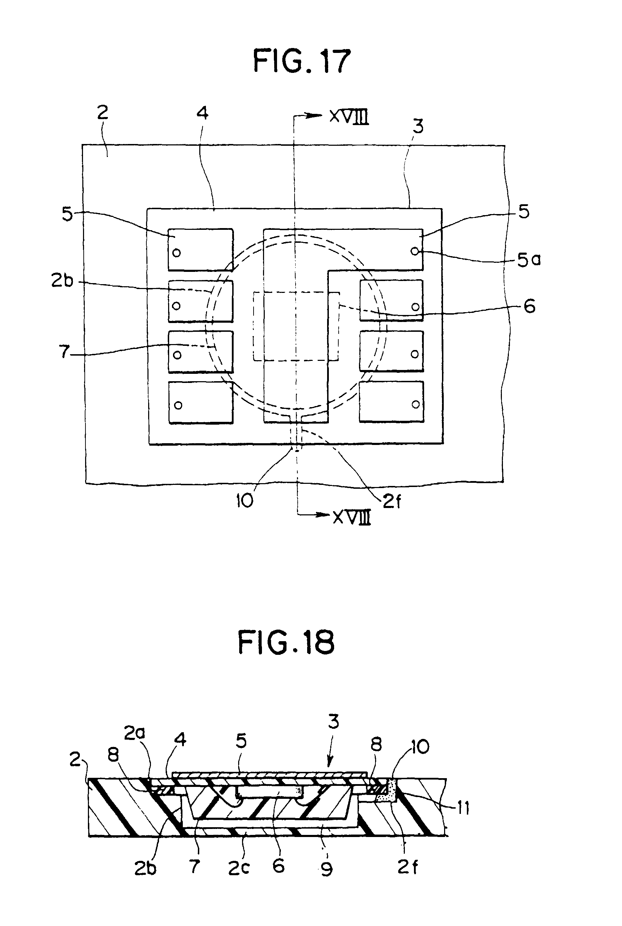

Figs. 17 and 18 show the third embodiment of the present invention. An opening 10 is formed in the card base 2, and the groove 2f is formed in the first recess 2a so as to communicate the space 9 with the opening 10. In the adhesive sheet 8, a notch is previously formed for communicating the opening 10 with groove 2f. Although the overlay or the printing and the hard coat are not shown in the drawings, it is applied to the card base 2 so as to hide the opening 10.

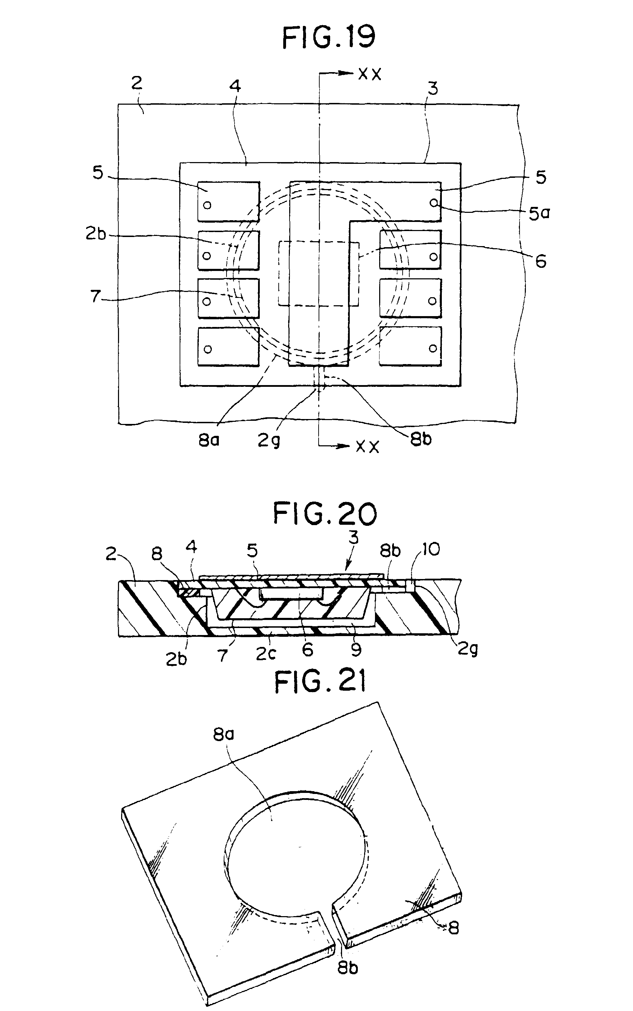

Referring to Figs. 19 to 21 the adhesive sheet 8 has a slit 8b communicating with the opening 8a for the IC module 3, and an opening 10 constituted by a notch 2g is formed in the card base 2 so as to be communicated with the slit 8b. Thus, the space 9 communicates with the atmosphere through the slit 8b and the opening 10.

As is apparent from the above description, in the IC card structure of the present invention, the IC module is mounted in the card base in such a way that the seal portion of the IC module is positioned in the second recess of the card base with a space between the card base and IC module, and the circuit board of the 10 module is fixed to the first recess of the card base with the thermo reactive adhesive sheet, and the IC card is provided with an opening for discharging the air from the space. Thus, some of the air in the space is discharged through the opening when the air expands. Consequently, the card base does not deform. In addition, the opening can be formed at a desired position in the card base and the circuit board of the IC module.

While the invention has been described in conjunction with preferred specific embodiments thereof, it will be understood that this description is intended to illustrate and not limit the scope of the invention, which is defined by the following claims.

## Claims

1. An IC card comprising:
a card base (1) made of synthetic resin and having a first recess (2a) and a second recess (2b) formed in said first recess; and
an IC module (3) having a circuit board (4), contact patterns (5) formed on said circuit board, an IC chip (6) mounted on said circuit board, said IC chip being connected to said contact patterns (5) by bonding wires, and a seal portion (7) sealing said IC chip and bonding wires;
said IC module (3) being mounted on said card base (1) such that said seal portion (7) of said IC module is positioned in said second recess (2b) with a space (9) between the card base and said IC module, and said circuit board (4) of said IC module being fixed on said first recess (2a) of said card base by a thermo reactive adhesive sheet (8),
characterised in that there is provided an opening (2d; 4a; 2f) between said space (9) and the outer surface of said IC card and said opening is not closed by said seal portion (7) but is closed by closure means (11, 12, 3) which is distinct from said seal portion (7).

2. The IC card according to claim 1, wherein said opening (2d) is formed in said card base (1).

3. The IC card according to claim 1, wherein said opening (4a) is formed in said circuit board (4) of said IC module.

4. The IC card according to claim 3, wherein said opening (2f) is a through hole formed in said circuit board (4) for connecting the contact pattern with the IC chip.

5. The IC card according to claim 2, wherein said opening (2d) is formed in the bottom of the second recess (2b) of the card base.

6. The IC card according to claim 1, wherein the inside wall of said second recess (2b) has an indentation (2e) and said opening (4a) opens to said indentation.

7. The IC card according to any preceding claim, wherein said closure means is a seal member (11).

8. The IC card according to claim 2, 3 or 5, wherein said closure means is an overlay or a coating (12).

## Patentansprüche

1. IS-Karte, mit:
einer Kartenbasis (1) aus einem Kunstharz und mit einer ersten Vertiefung (2a) und einer zweiten Vertiefung (2b), die in der ersten Vertiefung ausgebildet ist; und
einem integrierten Schaltkreismodul (3) mit einer Schaltplatte (4), wobei auf der Schaltplatte Kontaktmuster (5) ausgebildet sind, und wobei auf der Schaltplatte ein IS-Chip (6) angebracht ist, wobei der genannte IS-Chip durch Verbindungsdrähte mit den genannten Kontaktmustern (5) verbunden ist, und mit einem Verschlußteilstück (7), das den genannten IS-Chip und die genannten Verbindungsdrähte verschließt;
wobei das genannte integrierte Schaltkreismodul (3) so an der genannten Kartenbasis (1) angebracht ist, daß das genannte Verschlußteilstück (7) des genannten integrierten Schaltkreismoduls in der zweiten Vertiefung (2b) positioniert ist, wobei zwischen der Kartenbasis und dem integrierten Schaltkreismodul ein Zwischenraum (9) existiert, und wobei die Schaltplatte (4) des genannten integrierten Schaltkreismoduls durch eine wärmereaktionsfähige Klebstoffschicht (8) an der ersten Vertiefung (2a) der Kartenbasis befestigt ist,
dadurch gekennzeichnet, daß zwischen dem genannten Zwischenraum (9) und der Außenoberfläche der IS-Karte eine Öffnung (2d; 4a; 2f) vorgesehen ist, und wobei die genannte Öffnung nicht durch das genannte Verschlußteilstück (7) verschlossen wird, sondern durch eine Verschlußeinrichtung (11, 12, 3), die von dem genannten Verschlußteilstück (17) getrennt ist

2. IS-Karte nach Anspruch 1, dadurch gekennzeichnet, daß die genannte Öffnung (2d) in der genannten Kartenbasis (1) ausgebildet ist.

3. IS-Karte nach Anspruch 1, dadurch gekennzeichnet, daß die genannte Öffnung (4a) in der genannten Schaltplatte (4) des integrierten Schaltkreismoduls ausgebildet ist.

4. IS-Karte nach Anspruch 3, dadurch gekennzeichnet, daß es sich bei der Öffnung (2f) um eine durchgängige Öffnung handelt, die in der genannten Schaltplatte (4) ausgebildet ist, um die Kontaktmuster mit dem IS-Chip zu verbinden.

5. IS-Karte nach Anspruch 2, dadurch gekennzeichnet, daß die genannte Öffnung (2d) in der Unterseite der genannten zweiten Vertiefung (2b) der Kartenbasis ausgebildet ist.

6. IS-Karte nach Anspruch 1, dadurch gekennzeichnet, daß die Innenwand der genannten zweiten Vertiefung (2b) eine Einkerbung (2e) aufweist, und wobei die Öffnung (4a) zu der genannten Einkerbung hin offen ist.

7. IS-Karte nach einem der vorstehenden Ansprüche, dadurch gekennzeichnet, daß es sich bei der genannten Verschlußeinrichtung um ein Dichtungs- bzw. Verschlußelement (11) handelt.

8. IS-Karte nach einem der Ansprüche 2, 3 oder 5, dadurch gekennzeichnet, daß es sich bei der genannten Verschlußeinrichtung um eine Auflage oder einen Überzug (12) handelt.

## Revendications

1. Carte de circuit intégré CI comprenant :
une base de carte (1) fabriquée en résine synthétique et comportant un premier évidement (2a) et un deuxième évidement (2b) formé dans ledit premier évidement ; et
un module CI (3) comprenant une plaquette de circuit (4), des configurations de contact (5) formées sur ladite plaquette de circuit, une puce CI (6) montée sur ladite plaquette de circuit, et un encapsulage (7) de scellement de ladite puce CI ;
ledit module CI (3) étant monté sur ladite base de carte (1) de sorte que ledit encapsulage (7) du dit module CI se loge dans ledit deuxième évidement (2b) avec un espace (9) restant entre la base de carte et ledit mobile CI, et ladite plaquette de circuit (4) du dit module CI étant fixée sur ledit premier évidement (2a) de ladite base de carte par une feuille adhésive thermoréactive (8) ;
caractérisée en ce qu'un trou (2d;4a;2f) est prévu entre ledit espace (9) et la surface extérieure de la dite carte CI, et ledit trou n'est pas fermé par ledit encapsulage (7) mais est fermé par le moyen d'étanchéité (11,12,3) qui est distinct dudit encapsulage (7).

2. Carte CI suivant la revendication 1, dans laquelle ledit trou (2d) est formé dans ladite base de carte (1).

3. Carte CI suivant la revendication 1, dans laquelle ledit trou (4a) est formé dans ladite plaquette de circuit (4) dudit module CI.

4. Carte CI suivant la revendication 3, dans laquelle ledit trou (2f) est une traversée formée dans ladite plaquette de circuit (4) pour la connexion de la configuration de contact avec la puce CI.

5. Carte CI suivant la revendication 2, dans laquelle ledit trou (2d) est formé dans le fond du deuxième évidement (2b) de la base de carte.

6. Carte CI suivant la revendication 1, dans laquelle la paroi intérieure dudit deuxième évidement (2b) présente une indentation (2e) et ledit trou (4a) débouche dans ladite indentation.

7. Carte CI suivant une quelconque des revendications précédentes, dans laquelle ledit trou est fermé par un bouchon (11).

8. Carte CI suivant la revendication 2,3 ou 5, dans laquelle ledit moyen d'étanchéité est une couverture ou un revêtement (12).
